# EUROPEAN PATENT SPECIFICATION

(11) **EP 0 393 985 B1**
(45) Date of publication and mention of the grant of the patent: **09.11.1994**
(21) Application number: 90304104.4
(22) Date of filing: 17.04.1990
(51) Int. Cl.: C23C 16/24, C23C 16/50

(54) **Method for forming semiconductor thin film**
Methode zur Bildung einer dünnen Halbleiterschicht
Méthode de formation d'un film mince semi-conducteur

(30) Priority: 18.04.1989 JP 96348/89; 18.04.1989 JP 96349/89
(43) Date of publication of application: 24.10.1990
(73) Proprietor: MITSUI TOATSU CHEMICALS, Inc., Chiyoda-Ku Tokyo 100 (JP)
(72) Inventor: Ashida, Yoshinori, Yokohama-shi, Kanagawa-ken (JP); Koyama, Masato, Kamakura-shi, Kanagawa-ken (JP); Fukuda, Nobuhiro, Yokohama-shi, Kanagawa-ken (JP)
(74) Representative: Stuart, Ian Alexander

(56) References cited:
- DE-A- 2 904 171
- Proc. 7th E.C. Solar Energy Conference, Sevilla, October 1986, Reidel Publ. Co., Dordrecht, NL, pages 528-532; I. Pereyra et al.: "Influence of a DC electric field on hydrogen incorporation and doping efficiency of a-Si:H films"
- SOLAR CELLS, vol. 14, no. 3, July 1985, LAUSANNE, CH, pages 281-287; M.S. Sanematsu et al.: "Highly uniform large-area a-Si:H films"
- MATERIALS SCIENCE REPORTS, vol. 2, no. 4, August 1987, AMSTERDAM, NL, pages 139-184; K. Tanaka et al.: "Glow-discharge amorphous silicon: growth process and structure"
- Thin Solid Films, vol. 62, 1979, Elsevier Sequoia S.A., Lausanne, CH; J. Perrin et al.: "Optical properties and hydrogen concentration in amorphous silicon", pages 327-336.

## Description

This invention relates to a method for forming an amorphous semiconductor thin film, and more specifically to a method for forming a high-quality amorphous semiconductor thin film.

Amorphous solar cells basically formed by depositing amorphous semiconductor thin films of p-, i- and n-layers have been already put to practical use as an energy supply source of low output for actuating electric calculators or watches. Such solar cells however are not said to be sufficient as an energy supply source as power generation in the aspect of performance, stability and cost. Accordingly, various studies have been so far made to improve performance. In order to put amorphous solar cells into practical use, there is a need to produce solar cells having high conversion efficiency with good reproducibility and high throughput.

Nevertheless, since the amorphous solar cells are nowadays produced principally by a plasma CVD method, problems with reproducibility and production speed are not solved enough. For solving these problems, studies to deposit at high speed the i-layers which are the thickest of the thin film layers constituting the solar cells or attempts to shorten vacuum exhaustion time have been made, and stable discharge has been tried by designing of the plasma CVD apparatus including designing of a high-frequency powered electrode. However, from the standpoint of putting the solar cells into practical use, the results of these studies do not contribute enough toward solving the problems.

In order to solve the aforesaid problems, the present inventors have earnestly made studies on the factors such as high-frequency glow discharge mode, glow discharge decomposition of reactive gases, conditions of high-speed deposition, etc., and consequently found that when glow discharge is generated in the plasma CVD apparatus, change of a D.C. self-bias voltage applied naturally to a high-frequency powered electrode gives rise to a crucial problem. This finding led to completion of this invention.

The basic concept of this invention lies in that when forming a thin film by flow discharge in a plasma CVD apparatus, a D.C. bias voltage is applied to a high-frequency powered electrode and the change of the D.C. bias voltage results in changing a D.C. self-bias voltage, making it possible to optionally control the discharge mode. Accordingly, this invention can form a high-quality semiconductor thin film having good photo-electric characteristics at high deposition rate with good reproducibility by a method in which glow discharge is generated in a plasma CVD apparatus.

This invention relates to a method for forming an amorphous semiconductor thin film on a substrate which comprises:
(i) providing a reactor having:
   (a) a high frequency electrode for generating a glow discharge;
   (b) a substrate holder for holding a substrate facing said high frequency electrode;
   (c) means for applying an A.C. voltage to said electrode, said means including a matching circuit and being such that application of an A.C. voltage to said elctrode tends to generate a D.C.self-bias voltage at the electrode;
   (d) means for applying a D.C. voltage to said electrode independently from the A.C. voltage; and
   (e) means for feeding gas into the reactor;
(ii) applying an A.C. voltage to said electrode by said A.C. voltage applying means and thereby generating a D.C. self-bias voltage at the electrode;
(iii) applying a D.C. voltage in the range of +1000V to -1000V to said electrode by said D.C. voltage applying means;
(iv) feeding a reactive gas into the reactor by said feeding means to generate glow discharge of the reactive gas and maintain it, and forming the semiconductor thin film on the substrate; and wherein said application of D.C. voltage by said D.C. voltage applying means is arranged to change the D.C. self-bias voltage thereby to enhance the rate of deposition of semiconductor thin film.

### BRIEF DESCRIPTION OF THE DRAWINGS

Figure 1 is a diagramatic representation showing a device for forming an amorphous semiconductor thin film.

Figure 2 is a graph illustrating change in rate at which to form a semiconductor thin film when a D.C. voltage is changed from -100 V to +100 V.

### DESCRIPTION OF THE PREFERRED EMBODIMENTS

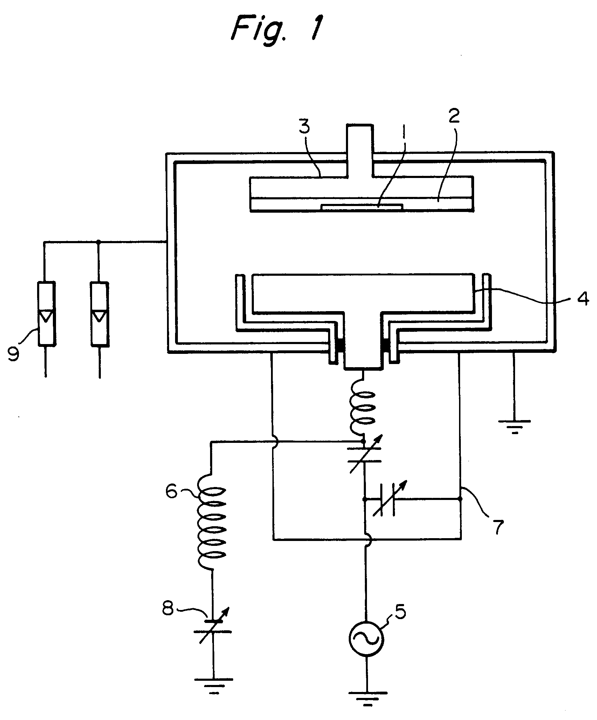

A preferable example of a CVD device for working this invention is shown in Figure 1. This device comprises a heater 3 for heating a substrate, a high-frequency powered electrode 4 for applying an A.C. voltage to generate a plasma, a high-frequency A.C. power supply 5, a substrate 1 on which surface a semiconductor thin film is formed, a substrate holder 2, a gas supply system (comprising a gas piping and a flowmeter) 9 for introducing a starting gas such as a reactive gas, etc. into a reactor, a constant-voltage regulated D.C. power supply 8 that can apply a constant D.C. voltage, a low pass filter 6 that prevents occurrence of simultaneous and mutual interference of A.C. and D.C. currents, a matching circuit 7, and so forth.

In this invention, the reactive gas being introduced to generate glow discharge is a gas composed mainly of a silane compound represented by formula SiₙH₂ₙ₊₂ (wherein n is a natural number). Examples of the reactive gas are monosilane, disilane, trisilane and tetrasilane. Monosilane, disilane, trisilane or their mixture is preferable in handling. The reactive gas is of course not limited thereto. Also available are fluorosilanes represented by formula SiₙH₂ₙ₊₂₋ₘFₘ (wherein m and n are natural numbers and m<2n+2), such as SiH₃F, SiH₂F₂, SiHF₃, SiF₄, Si₂F₆, Si₂HF₅ and Si₃F₈; chlorosilanes represented by formula SiₙH_{2n+d-m}Clₘ (wherein n and m are natural numbers and m<2n+2), such as SiH₃Cl, SiH₂Cl₂, SiHCl₃, SiCl₄, Si₂Cl₆, Si₂HCl₅ and Si₃Cl₈, germanes represented by GeₙH₂ₙ₊₂ (wherein n is a natural number), such as GeH₄ and Ge₂H₆; fluorogermanes represented by formula GeₙH₂ₙ₊₂₋ₘFₘ (wherein n and m are natural numbers and m<2n+2), such as GeF₄; organosilanes represented by formula SiₙR₂ₙ₊₂₋ₘHₘ (wherein R is an organic group, n and m are natural numbers, m<2n+2 and m may be zero), such as Si(CH₃)H₃, Si(CH₃)₂H₂ and Si(CH₃)₃H; and hydrocarbon gases such as CH₄ (methane), C₂H₆(ethane), C₃H₈(propane), C₂H₄ (ethylene) and C₂H₂(acetylene).

These silane compounds may be used either singly or by being diluted with reactive gases such as hydrogen, fluorine, and chlorine; gases containing elements of group III in the periodic table as a dopant, such as B₂H₆ (diboron) and B(CH₃)₃, and gases containing elements of group V in the periodic table, such as PH₃ (phosphine); inert gases such as helium, argon and neon; or support gases such as nitrogen. The dilution is within the range of 0.1 to 100 % by volume when expressed at a ratio of the silane compound to the diluent gas. Considering the actual deposition rate at which to form the semiconductor thin film, the dilution is preferably at least 1 percent.

The flow rate of the reactive gas is usually 1 to 200 sccm, and the glow discharge pressure is usually 0.7 Pa to 6.7x10³ Pa (5 mtorr to 50 torr). However, the flow rate and the pressure can optionally be selected depending on the film deposition rate.

The A.C. voltage used in this invention has preferably a frequency of 1 kHz or more. The upper limit is theoretically not limited in particular; actually, 50 MHz is preferable. Especially, 13.56 MHz allowable from the aspect of electric wave is preferable. The A.C. voltage being applied is about 10 V to 10 KV required to maintain the glow discharge, and preferably about 50 to 2,000 V.

In this invention, the D.C. voltage is applied, independently from the A.C. voltage, to the high-frequency powered electrode to which the A.C. voltage is applied. The D.C. voltage is, as shown in Figure 1, introduced from the constant-voltage regulated power supply 8 via the low pass filter 6 and applied to the high-frequency powered electrode. The D.C. voltage can vary with a size of an electrode, but is usually +1,000 to -1,000 V, preferably +500 to -500 V, more preferably +300 to -300 V, most preferably +200 to -200. The size of the electrode is about 50 to 15,000 cm². The D.C. voltage being applied is supplied from the constant-voltage regulated D.C. power supply 8 to maintain a constant voltage, and the change of the voltage is suppressed quite accurately and preferably within about ±10 V.

The substrate temperature is usually 50 to 500°C, preferably 150 to 350°C in view of heat resistance of the substrate and characteristics of the resulting film.

One type of the substrates available in this invention is a light-transmitting substrate. Examples of the light-transmitting substrate are ordinary glass substrates such as a soda lime glass, a borosilicate glass and a quartz glass, and substrates of films of high-molecular compounds such as polyethylene terephthalate and polyimide.

In this invention, an electrically conductive substrate is preferably used as a substrate. A substrate having specific resistance of 10⁴Ω·cm or less is preferable as the electrically conductive substrate. Concrete examples thereof are substrates of metals such as stainless steel, titanium, aluminum and molybdenum; substrates of glasses such as a borosilicate glass, a soda lime glass and a quartz glass; and substrates of films of high-molecular compounds such as polyethylene terephthalate and polyimide, on which surfaces a thin film layer of a metal such as stainless steel, molybdenum, titanium, silver or aluminum is coated. Moreover, substrates obtained by forming a transparent electrode on the surfaces of the aforesaid glass substrates, high-molecular compound film substrates or metal substrates can preferably be used. As the transparent electrode, metal oxides such as tin oxide, iridium oxide and zinc oxide, and light transmitting metal such as gold or silver etc. can effectively be used. A crystalline silicon substrate, a germanium substrate and a gallium arsenide substrate are also available.

The thickness of the substrate is 0.5 to 10 mm in case of the glasses, 10 to 500 micrometers in case of the high-molecular compound films and that of metal layer on the substrate is 50 nm to 2000 nm (500 to 20,000 Å). Moreover, the thickness of the amorphous semiconductor thin film formed on the substrate is about 10 nm (100 Å) to 10 micrometers (100,000 Å). The speed at which to form the thin film is 0.3 to 5 nm/sec (3 to 50 Å/sec), preferably about 0.5 to 3 nm/sec (5 to 30 Å/sec).

The following Examples and Comparative Examples illustrate this invention more specifically.

### EXAMPLE 1

The CVD apparatus shown in Figure 1 was used. Said apparatus comprises, as stated earlier, a heater for heating a substrate, an electrode for applying an A.C. voltage, a substrate on which a semiconductor thin film is formed, a gas supply system (comprising a gas piping and a flowmeter) for introducing a starting gas such as a reactive gas, etc. into a reactor, a constant-voltage regulated D.C. power supply that can apply a constant D.C. voltage and a low pass filter that prevents occurrence of simultaneous and mutual interference of A.C. and D.C. currents. A high-frequency power supply of 13.56 MHz was used as a power supply to generate plasma. The substrate was placed on a susceptor and mounted in the reactor. The substrate used was a borosilicate glass substrate. After air was removed to high vacuum, 30 sccm of disilane as a starting gas was introduced, a high-frequency voltage of 150 V was applied at a substrate temperature of 250°C and a reaction pressure of 0.1 torr, and a D.C. voltage of -200 V was simultaneously applied. Film formation was conducted with a power of 150 W for a given period of time to obtain a thin film having a thickness of 700 nm (7,000 Å). The resulting amorphous thin film was withdrawn from the reactor.

The properties of the thin film were measured. As a result, the conductivity (photoconductivity) under irradiation of 100 mW/cm² of simulated sunlight (AM-1.5) was 4 x 10⁻⁵ S/cm, the dark conductivity 3 x 10⁻¹¹S/cm, the optical band gap 1.77 eV, the activation energy 0.09 eV, the amount of bound hydrogen 17 at%, the film-deposition rate 2.3 nm/sec (23 Å/sec), respectively.

The properties of the film are equal to those of the film in Comparative Example 1 described below. However, the film-deposition rate in this Example was about thrice that in Comparative Example 1, and greatly improved. That is, in this Example, the film-deposition rate could greatly be improved while maintaining the properties of the film.

### COMPARATIVE EXAMPLE 1

EXAMPLE 1 was repeated except that the D.C. voltage was not applied from outside and discharge was generated by only a self-bias voltage. There resulted a film having a given thickness of 400 nm (4,000 Å).

The properties of the resulting thin film were measured. Consequently, the photoconductivity was 3 x 10⁻⁵ S/cm, the dark conductivity 5 x 10⁻¹¹ S/cm, the amount of bound hydrogen 12 at%, and the film-deposition rate 0.9 nm/sec (9 Å/sec), respectively.

### EXAMPLE 2

The same CVD apparatus as in EXAMPLE 1 was used, provided a glass substrate having a specific resistance of 2 x 10⁻⁴Ω·cm and to which tin oxide (SnO₂) was coated to a thickness of 800 nm (8,000 Å) was used as the substrate.

After air was removed to high vacuum, 25 sccm of disilane as a starting gas was introduced. A high-frequency voltage of 170 V was applied at a substrate temperature of 250°C and a reaction pressure of 13 Pa (0.1 torr), and a D.C. voltage was simultaneously applied by varying it within the range of -100 V to +100 V. Film formation was conducted for a given period of time to provide a 1 micrometer thick amorphous thin film. The thin film was withdrawn from the reactor.

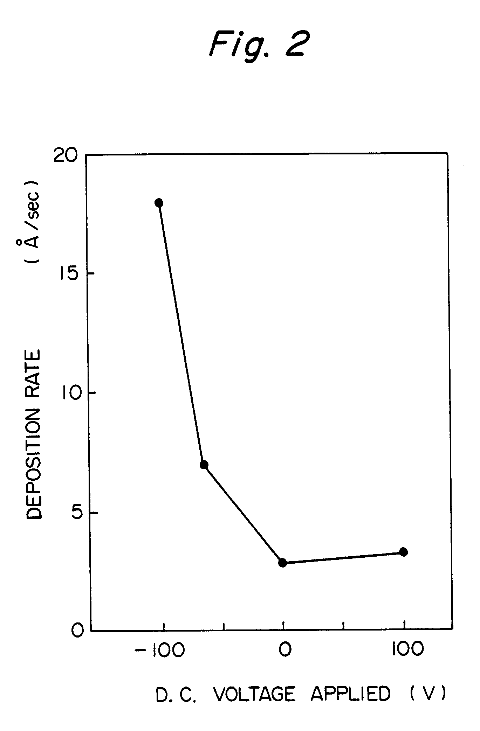

The relationship between the film-deposition rate and the D.C. voltage applied is shown in Figure 2.

The properties of the film formed by applying -100 V were measured. As a result, the conductivity (photoconductivity) under irradiation of 100 mW/cm² of simulated sunlight (AM-1.5) was 2 x 10⁻⁵ S/cm, the dark conductivity 1 x 10⁻¹¹ S/cm, the optical band gap 1.75 eV, the activation energy 0.89 eV, the amount of bound hydrogen 17 at%, and the film-deposition rate 1.8 nm/sec (18 Å/sec), respectively.

The properties of this film are equal to those of the film in COMPARATIVE EXAMPLE 2 described below. The film-deposition rate in this Example was however about thrice that in Comparative Example 2. Namely, in this Example, the film-deposition rate could greatly be increased while maintaining the properties of the film.

Moreover, a pin-type amorphous solar cell was produced using a substrate obtained by coating tin oxide to 800 nm (8,000 Å) on a glass substrate. Using a 20 nm (200 Å)-thick p-type a-SiC layer as a p-layer, a 50 nm (500 Å)-thick n-type µc-Si layer, and a 700 nm (7,000 Å)-thick layer formed at a film-deposition rate of 1.5 nm/sec (15 Å/sec) by the method of this invention as an i-layer, a solar battery was produced.

The current-voltage characteristics under irradiation of light (simulated sunlight) were measured on this solar cell. As a result, the open circuit voltage was 0.86 V, the circuit current 17.5 mA/cm², the fill factor 0.678, and the conversion efficiency 10.2 %, respectively. These data indicate that this invention is quite effective and extremely excellent compared to the prior art.

### COMPARATIVE EXAMPLE 2

EXAMPLE 2 was repeated except that discharge was generated with a self-bias voltage alone without applying a D.C. voltage from outside, and a thin film having a thickness of about 1 micron was formed.

The properties of the resulting thin film were measured. As a result, the photoconductivity was 4 x 10⁻⁵ S/cm, the dark conductivity 5 x 10⁻¹¹ S/cm, the amount of bound hydrogen 12 at%, and the film-deposition rate 0.6 nm/sec (6 Å/sec), respectively.

From the foregoing Examples and Comparative Examples, it follows that the method of this invention can form the amorphous semiconductor thin film having quite good photoelectric properties at the quite high deposition rate. Accordingly, this invention much contributes to improvement in photoelectric conversion efficiency of the amorphous solar cells. This invention that can provide a technology to allow high conversion efficiency required of the solar cells for electric power is thus an extremely useful invention in the energy industry.

## Claims

1. A method for forming an amorphous semiconductor thin film on a substrate which comprises:
(i) providing a reactor having:
(a) a high frequency electrode (4) for generating a glow discharge;
(b) a substrate holder (2) for holding a substrate (1) facing said high frequency electrode (4);
(c) means (5,7) for applying an A.C. voltage to said electrode (4), said means (5,7) including a matching circuit (7) and being such that application of an A.C. voltage to said electrode (4) tends to generate a D.C.self-bias voltage at the electrode (4);
(d) means (6,8) for applying a D.C. voltage to said electrode (4) independently from the A.C. voltage; and
(e) means (9) for feeding gas into the reactor;
(ii) applying an A.C. voltage to said electrode (4) by said A.C. voltage applying means (5,7) and thereby generating a D.C. self-bias voltage at the electrode (4);
(iii) applying a D.C. voltage in the range of +1000V to -1000V to said electrode (4) by said D.C. voltage applying means (6,8);
(iv) feeding a reactive gas into the reactor by said feeding means (9) to generate glow discharge of the reactive gas and maintain it, and forming the semiconductor thin film on the substrate; and wherein said application of D.C. voltage by said D.C. voltge applying means (6,8) is arranged to change the D.C. self-bias voltage thereby to enhance the rate of deposition of semiconductor thin film.

2. The method of claim 1 wherein the substrate comprises a glass.

3. The method of claim 1 or 2 wherein the substrate is an electrically conductive substrate.

4. The method of any preceding claim wherein the DC voltage is in the range of +200 V to -200 V.

5. The method of any preceding claim wherein the DC voltage is negative.

6. The method of claim 5 wherein the negative voltage has a magnitude of at least 50V.

7. The method of any preceding claim wherein said electrode has an area of 50 - 15000 cm².

## Patentansprüche

1. Verfahren zur Bildung einer amorphen Halbleiterdünnschicht, umfassend:
(i) das Vorsehen eines Reaktors mit:
(a) einer Hochfrequenzelektrode (4) zum Erzeugen einer Glimmentladung;
(b) einer Substrathalterung (2) zum Halten eines der genannten Hochfrequenzelektrode (4) zugewandten Substrats (1);
(c) Mitteln (5,7) zum Anlegen einer Wechselspannung an die genannte Elektrode (4), wobei die genannten Mittel (5,7) eine Anpassungsschaltung (7) enthalten und solcherart sind, daß das Anlegen einer Wechselspannung an die genannte Elektrode (4) dazu neigt, an der Elektrode (4) eine selbsteinstellende Gleichvorspannung zu erzeugen;
(d) Mitteln (6,8) zum Anlegen einer Gleichspannung an die genannte Elektrode (4) unabhängig von der Wechselspannung;
(e) Mitteln (9) zum Einleiten von Gas in den Reaktor;
(ii) Anlegen einer Wechselspannung an die genannte Elektrode (4) durch die genannten Wechselspannungs-Anlegungsmittel (5,7) und dadurch das Erzeugen einer selbsteinstellenden Gleichvorspannung an der Elektrode (4);
(iii) das Anlegen einer Gleichspannung im Bereich von +1000V bis -1000V an die genannte Elektrode (4) durch die genannten Gleichspannungs-Anlegungsmittel (6,8);
(iv) das Einleiten eines reaktiven Gases in den Reaktor durch die genannten Einleitungsmittel (9) zur Erzeugung der Glimmentladung des reaktiven Gases und ihrer Aufrechterhaltung sowie das Bilden der Halbleiterdünnschicht auf dem Substrat; und worin das genannte Anlegen von Gleichspannung durch die genannten Gleichspannungs-Anlegungsmittel (6,8) die selbsteinstellende Gleichvorspannung ändert, um dadurch die Ablagerungsrate der Halbleiterdünnschicht zu verbessern.

2. Verfahren nach Anspruch 1, worin das Substrat ein Glas umfaßt.

3. Verfahren nach Anspruch 1 oder 2, worin das Substrat ein elektrisch leitendes Substrat ist.

4. Verfahren nach einem der vorhergehenden Ansprüche, worin die Gleichspannung im Bereich von +200V bis -200V liegt.

5. Verfahren nach einem der vorhergehenden Ansprüche, worin die Gleichspannung negativ ist.

6. Verfahren nach Anspruch 5, worin die negative Spannung einen Wert von zumindest 50V aufweist.

7. Verfahren nach einem der vorhergehenden Ansprüche, worin die genannte Elektrode eine Fläche von 50 - 15.000 cm² aufweist.

## Revendications

1. Procédé pour former un film mince semi-conducteur amorphe sur un substrat qui comprend :
(i) réaliser un réacteur ayant :
(a) une électrode haute fréquence (4) pour produire une décharge luminescente ;
(b) un support du substrat (2) pour maintenir un substrat (1) faisant face à l'électrode haute fréquence (4) ;
(c) un moyen (5, 7) pour appliquer une tension alternative à l'électrode (4), le moyen (5, 7) comprenant un circuit d'accord (7) et étant tel que l'application d'une tension alternative à l'électrode (4) tend à produire une tension continue de polarisation automatique a l'électrode (4) ;
(d) un moyen (6, 8) pour appliquer une tension continue à l'électrode (4) indépendamment de la tension alternative ; et
(e) un moyen (9) pour fournir du gaz dans le réacteur ;
(ii) appliquer une tension alternative à l'électrode (4) par le moyen d'application de tension alternative (5, 7) et produire de la sorte une tension continue de polarisation automatique à l'électrode (4) ;
(iii) appliquer une tension continue dans la gamme de +1000V à -1000V à l'électrode (4) par le moyen d'application de tension continue (6, 8) ;
(iv) fournir un gaz réactif dans le réacteur par le moyen d'alimentation (9) pour produire une décharge luminescente du gaz réactif et la maintenir, et former le film mince semi-conducteur sur le substrat ; et dans lequel l'application de la tension continue par le moyen d'application de tension continue (6, 8) est agencée pour changer la tension continue de polarisation automatique pour augmenter de la sorte le taux de dépôt du film mince semi-conducteur.

2. Procédé de la revendication 1 dans lequel le substrat comprend un verre.

3. Procédé de la revendication 1 ou 2 dans lequel le substrat est un substrat électriquement conducteur.

4. Procédé de l'une quelconque des revendications précédentes dans lequel la tension continue est dans la gamme de +200V à -200V.

5. Procédé de l'une quelconque des revendications précédentes dans lequel la tension continue est négative.

6. Procédé de la revendication 5 dans lequel la tension négative a une grandeur d'au moins 50V.

7. Procédé de l'une quelconque des revendications précédentes dans lequel l'électrode précitée a une surface de 50 - 15000 Cm².
